## Europäisches Patentamt

## European Patent Office

## Office européen des brevets

(11) Publication number: **0 069 570**
**B1**

# (12) EUROPEAN PATENT SPECIFICATION

(45) Date of publication of patent specification: **11.11.87**

(51) Int. Cl.⁴: **G 06 F 12/04, G 11 C 17/00**

(21) Application number: **82303510.0**

(22) Date of filing: **05.07.82**

(54) Memory for multi-word data bus.

(30) Priority: **06.07.81 US 280720**

(43) Date of publication of application:
**12.01.83 Bulletin 83/02**

(45) Publication of the grant of the patent:
**11.11.87 Bulletin 87/46**

(84) Designated Contracting States:
**DE FR GB IT NL SE**

(56) References cited:
**GB-A-1 254 929**

**COMPUTER DESIGN, vol. 9, no. 10, October
1970, pages 95-97, Concord, US; J.A.HOWARD
et al.: "An ROM bootstrap loader for small
computers"**

**COMPUTER DESIGN, vol. 10, no. 3, March
1971, page 16, Concord, US; G.SCHLITT:
"Letters to the editor"**

(73) Proprietor: **Honeywell Bull Inc.
3800 W. 80th Street
Minneapolis Minnesota 55431 (US)**

(72) Inventor: **Cushing, David E.
15 Trotting Road
Chelmsford Massachusetts (US)**
Inventor: **Stanley, Philip E.
40 Harvey Lane
Westboro Massachusetts (US)**

(74) Representative: **Geissler, Bernhard, Dr. Patent-
und Rechtsanwälte
Bardehle-Pagenberg-Dost- Altenburg-
Frohwitter & Partner Postfach 86 06 20
D-8000 München 86 (DE)**

## Description

The invention relates to a computer memory, and more particularly to a memory in which multiple words of data can be transferred over a multiple word wide data bus.

In most modern computer systems, the data within memory is organized into fixed length words, each of a fixed number of bits. In many modern minicomputers, the word length is 16 bits.

Minicomputers have now evolved to the point where super-minicomputers are now appearing. These super-minicomputers are of higher performance than minicomputers. Because the cost of developing software is relatively high compared to the price of a super-minicomputer, manufacturers of super-minicomputers normally make the super-minicomputers software compatible with their earlier minicomputers so that software which executes on the minicomputer will also execute on the super-minicomputer.

One way of increasing the performance of a minicomputer to produce a super-minicomputer is to have the super-minicomputer process multiple words of data in parallel, so that when the super-minicomputer references the memory and provides a memory address of a 16-bit data word, the memory of the super-minicomputer will retrieve or store multiple 16-bit words in parallel. For example, if the CPU of a super-minicomputer wants to read location 768 from memory, the CPU can place the address of location 768 on the address bus and the main memory will retrieve the contents of location 768 and location 769 (the next addressed location) and return the two 16-bit data words in parallel on a data bus which is 32 bits wide (twice as wide as the 16-bit data bus on the previous minicomputer).

One method of organizaing the memory of a super-minicomputer so that it can retrieve two words in parallel is to organize the memory as an even bank and an odd bank, so that all even-addressed words are contained in the even bank and all odd-addressed words are contained in the odd bank. Using this organization, if location 768 and location 769 are to be read from main memory, the main memory will read the contents of location 768 from the even bank and the contents of location 769 from the odd bank and place them on the bus so that the left word on the data bus comes from the location with the originally given address and the right word on the data bus from the address location plus 1. In this example, location 768 from the even bank would be in the left word on the data bus and the contents of location of 769 from the odd bank would be in the right word of the data bus. However, if locations 769 and 770 are to be read from memory, location 769 would be read from the odd bank and placed in the left word on the data bus and location 770 would be read from the even bank and placed in the right word on the data bus.

It is evident that in some cases the word read from the even bank appears in the left word on the data bus; in the other cases, the word read from the odd bank will appear in the left word on the data bus. In order to achieve this alignment of the words on a multiword wide data bus, there is usually a crossbar arrangement within the main memory to align the data as it is read from memory and placed on the data bus or to align the data as it is taken from the data bus and written into the main memory. In addition to this crossbar logic, the main memory must also have the ability to increment by 1 the address presented by the address bus so that it may compute the address of the second location to be read from memory.

This crossbarring of the data from or to the data bus as this information is written to or read from main memory and the incrementing of the address requires logic within the memory. The propagation time of the various signals through the address incrementing and crossbarring logic increases the memory response time.

What is needed, therefore, is a means for eliminating the need of crossbarring data as multiple words of data are read from memory in parallel and the need to increment the address of the first word of multiple words of data which are to be retrieved from a memory.

Accordingly the present invention provides a computer system having a data bus with a width of N logical words, $N > 1$, a memory coupled to the bus and responsive to a word address to provide the N words with consecutive addresses starting with the address supplied, characterized in that the memory comprises a plurality of physical locations with consecutive physical addresses, and each physical location stores the N words with word addresses which run consecutively from the physical address of that location.

It will be realized that this is particularly useful for read-only memories. It is possible to use this principle in a read-write memory, as will be discussed later, but there is a heavy penalty in write time. Hence the principle will find its main application in read-only memories, as just noted, and in memories in which there is a very small amount of writing.

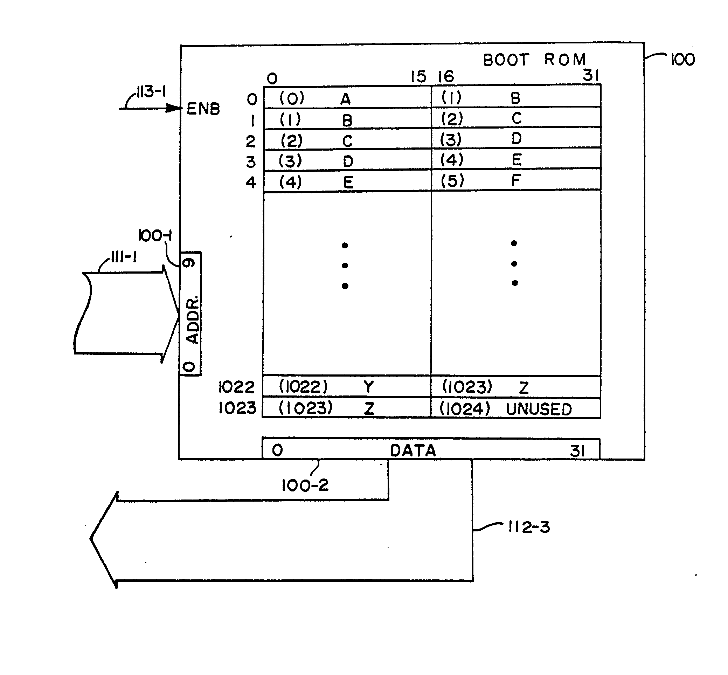

A read-only memory embodying the invention will now be described, by way of example, with reference to the drawing, which is a block diagram of the memory.

The drawing shows a boot ROM 100 (i.e. a ROM used to store bootstrap routines). The ROM 100 contains 1024 (1K) physical words of 32 bits each which is organized to be the equivalent of 1024 different logical words of 16 bits each. The numbers without parentheses (those outside the blocks representing logical 16-bit data words) represent the physical addresses of the 32-bit data words, each of which contains two 16-bit logical words with physical addresses ranging from 0 to 1023. The numbers within parentheses (those appearing inside the blocks representing the 16-bit logical words) represent the logical addresses of the 16-bit logical words in boot ROM 100 and range from 0 to 1024. The letters (those appearing inside the blocks representing the 16-bit logical data words) represent the contents of the 16-bit logical data words. For example, physical location 2 of boot ROM 100 contains signal locations 2 and 3 the contents of which are 16-bit logical words containing C and D respectively.

When a pair of words is to be retrieved from boot ROM 100, a control signal on control line 113-1 is fed to the enable (ENB) input of boot ROM 100, and a 10-bit address on an address bus 111-1 is fed to the address (ADDR.) inputs 100-1 of boot ROM 100. The 32-bit physical data word read from boot ROM 100 appears at outputs 100-2 and is fed out on data bus 112-3 without requiring any switching (crossbarring) of the two 16-bit logical data words before they are presented to data bus 112-3.

As described above, boot ROM 100 contains 1024 (1K) words of 32 bits each, organized to be equivalent to 1024 logical words of 16-bits each. In boot ROM 100, each physical 32-bit word contains two logical 16-bit words. In each physical 32-bit word, the leftmost logical 16-bit word contains the contents of the logical word having a logical address that is the same as the physical address of the 32-bit word that contains it. The rightmost logical 16-bit word contains the contents of the logical word having the logical address that is 1 greater than the physical address of the 32-bit word that contains it. Thus, for example, physical location 1 contains logical locations 1 and 2 and physical location 2 contains logical locations 2 and 3. This results in each 16-bit logical data word, with the exception of the logical locations 0 and 1024, being duplicated in boot ROM 100. Duplicating the data in this manner allows one 32-bit word to be retrieved from boot ROM 100 which always contains the proper two 16-bit data words, regardless whether an even or an odd address is presented to the boot ROM.

This arrangement eliminates the need for crossbarring the output of an odd and even bank and also the need for incrementing to obtain the address for the even bank. This eliminates logic within the boot ROM and results in the ROM containing fewer circuit components, thus involving less logic during the initial execution of the program from the boot memory. This helps assure that for diagnostic purposes less logic is involved during the initial loading of the software from the boot ROM.

If the boot memory 100 is being used in a system also containing a conventional main memory, with 2 banks, crossbarring, and address incrementing for the even bank, it may be desirable for the memory timing to be identical for both memories. In this case, the boot memory 100 can be constructed of slower and lower cost components. Also, particularly with a relatively small memory, the cost saving resulting from the elimination of the 2 bank construction, crossbarring, and address incrementing may well outweigh the extra cost of providing doubled memory space.

Although the preferred embodiment is a read only memory the present principles can also be applied to a read/write memory. In such a case, the reading operations would be performed as described above but write operations would require each 16-bit logical data word to be stored twice within the memory, once in the rightmost 16 bits of the physical word having a physical address of 1 less than the logical address and once in the leftmost 16 bits of the physical address having a physical address the same as the logical address. For example, a logical word having an address of 3 would be stored in the rightmost 16 bits of physical word 2 and the leftmost 16 bits of physical word 3. This could be achieved by presenting each logical word sequentially along with its logical address or by presenting multiple consecutive logical words in parallel along with the address of the first logical word. In either case, multiple writes in memory would be required.

If multiple words are to be stored in parallel the number of writes to memory increases. For example, if logical words 3 and 4 are presented to memory in parallel, they could be immediately stored in physical location 3 without alignment, followed by an interchange (crossbarring) of the two logical words such that logical word 4 is in the leftmost position and logical word 3 is in the rightmost position. Physical location 2 could then be read from the memory and then rewritten with the new logical word 3 replacing the old logical word 3 in the rightmost position. Physical location 4 could then be read from the memory and then rewritten with the new logical word 4 replacing the old logical word 4 in the leftmost position. As can be appreciated, this process requires address decrementing and incrementing logic and data crossbarring logic and multiple memory reads and writes, but could be useful if the advantages of a fast multiword information retrieval offsets the disadvantages of slow information storage.

The present principles can obviously be used if the data bus is more than 2 words wide. If for example three words are to be read in parallel, physical word in the ROM would contain three logical words. The contents of physical location 10 would contain logical location 10 at the left, logical location 11 in the middle, and logical location 12 at the right, etc. Thus each logical word will appear in the ROM as many times as the number of words to be read in parallel. Also, of course, the physical locations of the individual bits of the logical words in each physical word may be arranged in a more complicated manner.

## Claims

1. In a computer system having a data bus with a width of N logical words, N > 1, a memory coupled to the bus and responsive to a word address (e.g. 3) to provide the N words (D, E) with consecutive addresses (3, 4) starting with the address supplied, characterized in that the memory comprises a plurality of physical locations (0 to 1023) with consecutive physical addresses, and each physical location (e.g. 3) stores the N words with word addresses ((3) and (4)) which run consecutively from the physical address of that location.

2. A memory according to Claim 1, characterized in that it is a read-only memory having the words permanently stored therein.

3. A memory according to Claim 1, characterized by write means responsive to the receipt of a word to store the word successively in the N physical locations which run consecutively from the word address.

4. A memory according to Claim 1, characterized by write means responsive to the receipt of N consecutive words and the word address of the first of the N words to write the words into the memory by means of address increments and decrements and data alignment.

## Patentansprüche

1. Computersystem mit einem Datenbus mit einer Breite von N logischen Wörtern N > 1, mit einem mit dem Bus gekuppelten und auf eine Wortadresse (z.B. 3) reagierenden Speicher, um die N Worte (D, E) mit fortlaufenden Adressen (3, 4), beginnend mit der gelieferten Adresse, zu versehen, dadurch gekennzeichnet, daß der Speicher eine Vielzahl von Speicherplätzen (Positionen 0 bis 1023) mit aufeinanderfolgenden physikalischen Adressen umfaßt, und daß jeder Speicherplatz (z.B. Position 3) die N Wörter mit Wortadressen ((3) und (4)) speichert, die fortlaufend von der physikalischen Adresse dieser Position läuft.

2. Speicher nach Anspruch 1, dadurch gekennzeichnet, daß der Speicher ein ROM (read only memory) ist, der die Wörter permanent speichert.

3. Speicher nach Anspruch 1, gekennzeichnet durch Schreibeinrichtungen, die auf den Empfang eines Wortes ansprechen, um das Wort in den N Speicherplätzen aufeinanderfolgend zu speichern, die von der Wortadresse aufeinanderfolgend laufen.

4. Speicher nach Anspruch 1, gekennzeichnet durch Schreibeinrichtungen, die auf den Empfang von N aufeinanderfolgenden Wörtern und auf die Wortadresse des ersten der N Wörter ansprechen, um die Wörter mittels schrittweiser Auf- und Abadressierung und Datenzuordnung in den Speicher zu schreiben.

## Revendications

1. Dans un système ordinateur comportant un bus de données ayant une largeur de N mots logiques, où N > 1, une mémoire couplée au bus et réagissant à une adresse de mot (par exemple, 3) pour fournir les N mots (D, E) avec des adresses consécutives (3, 4) commençant par l'adresse fournie, est caractérisée en ce que la mémoire comprend un ensemble d'emplacements physiques (0 à 1023) d'adresses physiques consécutives, et en ce que chaque emplacement physique (par exemple, 3) contient les N mots avec des adresses de mots ((3) et (4)) qui se suivent consécutivement à partir de l'adresse physique de cet emplacement.

2. Mémoire selon la revendication 1, caractérisée en ce qu'elle est une mémoire morte dans laquelle sont mémorisés en permanence les mots.

3. Mémoire selon la revendication 1, caractérisée par un moyen d'écriture réagissant à la réception d'un mot pour mémoriser le mot successivement aux N emplacements physiques qui se suivent consécutivement à partir de l'adresse de mot.

4. Mémoire selon la revendication 1, caractérisée par un moyen d'écriture réagissant à la réception de N mots consécutifs et à l'adresse de mot du premier des N mots pour écrire les mots en mémoire au moyen d'incrémentations et de décrémentations d'adresse et d'un alignement de données.

BOOT ROM — 100

| | 0 | 15 | 16 | 31 |
|---|---|---|---|---|
| 0 | (0) A | | (1) B | |
| 1 | (1) B | | (2) C | |
| 2 | (2) C | | (3) D | |
| 3 | (3) D | | (4) E | |
| 4 | (4) E | | (5) F | |
| 1022 | (1022) Y | | (1023) Z | |
| 1023 | (1023) Z | | (1024) UNUSED | |

113-1 → ENB

9 ADDR. 0 — 100-1

111-1

0 DATA 31 — 100-2

112-3